# EUROPEAN PATENT SPECIFICATION

(11) **EP 0 354 853 B1**
(45) Date of publication and mention of the grant of the patent: **10.05.1995**
(21) Application number: 89402272.2
(22) Date of filing: 10.08.1989
(51) Int. Cl.: H01L 31/09, H01L 31/20, H01L 31/101, H01L 31/0288, C23C 16/24, C23C 16/50

(54) **Amorphous silicon photodiode and method of producing the same**
Photodiode aus amorphem Silizium und ihr Herstellungsverfahren
Photodiode en silicium amorphe et procédé pour sa fabrication

(30) Priority: 12.08.1988 JP 201066/88
(43) Date of publication of application: 14.02.1990
(73) Proprietor: FUJITSU LIMITED, Kawasaki-shi, Kanagawa 211 (JP)
(72) Inventor: Takasaki, Kanetake, Omorikita 1-chome Ota-ku Tokyo 143 (JP)
(74) Representative: Joly, Jean-Jacques

(56) References cited:
- EP-A- 0 215 968
- DE-A- 3 506 657
- Materials Research Society Symposia Proceedings vol. 49, 1985, New York, pages 423-428; S. Kaneko et al.: "Amorphous Si:H heterojunction photodiode and its application to a compact scanner"
- SOLAR CELLS, vol. 24, no. 3-4, August 1988, LAUSANNE CH, pages 287-297; J.D. Cohen et al.: "Junction capacitance studies of deep defects in undoped hydrogenated amorphous silicon" - Paper presented at the 8th Photovoltaic ... Meeting, 15-18 November 1987
- SOLAR CELLS, vol. 19, no. 2, December 1986, LAUSANNE CH, pages 179-188; C.R. Dickson et al.: "Amorphous silicon solar cell modules fabricated with a single-chamber load-lock deposition system"
- PATENT ABSTRACTS OF JAPAN vol. 12, no. 423 (E-680) 09 November 1988 & JP-A-63 160335
- Photovoltaic Power Generation, Proc. 2nd Contractors' Meeting, Hamburg, 16-18 September 1987, Kluwer Acad. Publ., Dordrecht, pages 131-136; L.J.M. Guimaraes et al.: "Electro-optical properties of a-Si:H ... undoped and doped films produced by a TCDDC system"
- JAPANESE JOURNAL OF APPLIED PHYSICS, vol. 26, no. 1, January 1987, TOKYO JP, pages 33-38; S. Tsuda et al.: "Preparation and Properties of High-Quality a-Si Films with a Super Chamber (Separated Ultra-High Vacuum Reaction Chamber)"
- Proc 7th E.C. Photovoltaic Solar Energy Conf., Sevilla, 27-31 October 1986, Reidel Pub. Compo., Dordrecht pages 549-554; G. Conte et al.: "Contamination effects in p-i-n amorphous silicon solar cells: change in the characteristics of the intrinsic layer"

## Description

### BACKGROUND OF THE INVENTION

### 1. Field of the Invention

The present invention relates to a photodiode, and more particularly, to an amorphous silicon photodiode and a method of producing the same.

An image sensor, e.g., a contact linear image sensor, is now widely used in facsimile machines, and is composed of a photodiode wherein a hydrogenated amorphous silicon (a-Si:H) is used as a photoconductor material. The amorphous silicon photoconductor has a good responsitivity and a spectral sensitivity similar to that of the human eye, and large number of these amorphous silicon photodiodes are used to produce a (solid state) image sensor such as an linear image sensor for a facsimile machine or an optical character reader (OCR) or the like. The resultant image sensor is advantageous in that it has a smaller dark current and a shorter residual image.

### 2. Description of the Related Art

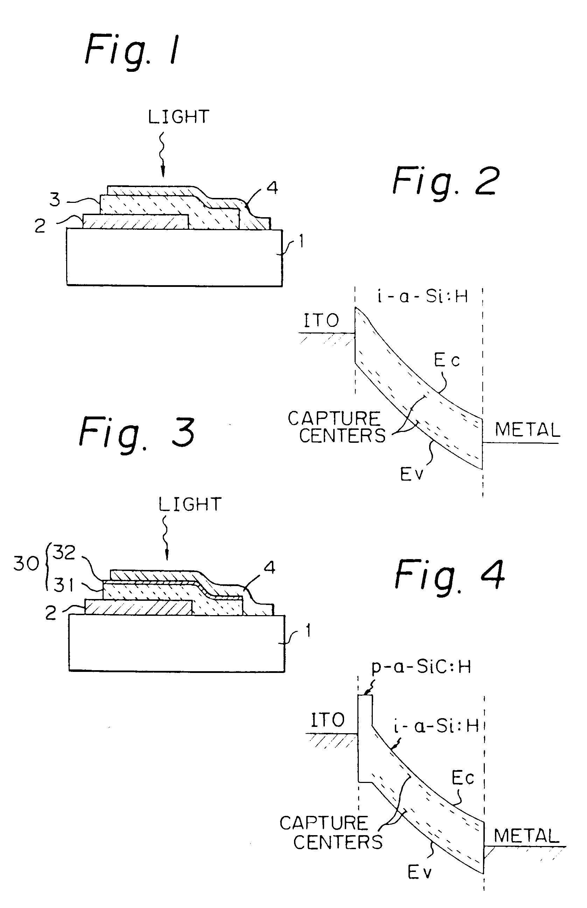

As shown in Fig. 1, an amorphous silicon photodiode comprises an insulating substrate 1, such as a glass, a lower electrode 2 of a metal (e.g., chromium) film, an amorphous silicon film 3, and an upper electrode 4 of a transparent conductive (e.g., indium tin oxide: ITO) film. The photodiode is produced by forming, in sequence, the chromium electrode film 2, the amorphous silicon film 3, and the ITO film 4 on the substrate 1. The amorphous silicon layer film 3 is produced by a plasma deposition of undoped (i-type) a-Si:H from SiH₄ gas in a plasma CVD (chemical vapor deposition) apparatus.

When a negative bias is applied to the ITO film 4 of the photodiode, the energy band diagram thereof shown in Fig. 2 is obtained.

Another type of amorphous silicon photodiode has a double layer structure amorphous silicon film 30, as shown in Fig. 3. The film 30 consists of an a-Si:H film 31 and a hydrogenated amorphous silicon carbide (a-SiC:H) film 32 thinner than the film 31. In this case, the substrate 1, the lower electrode 2, and the upper electrode 4 are the same as those shown in Fig. 1. The double layer amorphous silicon film 30 is produced by a plasma deposition of undoped (i-type) a-Si:H in a plasma CVD apparatus, followed by a plasma deposition of doped (p-type) a-SiC:H from a SiH₄, CH₄ and B₂H₆ mixed gas in another plasma CVD apparatus (cf. S. KANEKO et al: "Amorphous Si:H Heterojunction Photodiode and its Application to a Compact Scanner", Mat. Res. Soc. Symp. Proc. Vol. 49, 1985, pp. 423-428).

When a negative bias is applied to the ITO film 4 of the photodiode, an energy band diagram thereof shown in Fig. 4. is obtained. A problem arises in an image sensor comprising conventional amorphous silicon photodiodes, in that the residual image is relatively large. Namely, after a light pulse illumination to the amorphous silicon photodiode is finished, a residual electric current flows and declines to a dark current level. For example, the ratio of the residual current value to a photo-current value generated by a light illumination at a certain time (e.g., 50 m seconds) after the stop of light illumination is 5% or more. Hole-electron pairs are generated in the amorphous silicon film of the photodiode by light illumination and some electrons and holes are trapped by capture centers (localized levels) located near the conduction band and valence band in the forbidden band, and after the light illumination is stopped, the trapped electrons and holes are thermally excited and emitted to the conduction band and valence band, respectively, from the capture centers, with the result that the residual current flows. Therefore where a large number of the capture centers exist in the forbidden band of the amorphous silicon, the residual current flows continuously and the ratio of the residual current to the current under illumination is relatively large.

For a discussion on the preparation and characterization of high-quality a-Si films, reference can be made to Japanese Journal of Applied Physics, Vol. 26, No. 1, January 1987, pages 33-38. As far as carbon contamination is concerned, the paper reports on levels down to 2.10¹⁸ atoms/cm³.

A study of the effect of deep defects in undoped hydrogenated silicon on junction capacitance can be found in Solar Cells, Vol. 24, No. 3-4, July-August 1988 pages 287-297. The paper reports on a metastable defect density depending on the level of carbon concentration.

An example of an a-Si photodiode having a double layer construction as defined in the preamble of claim 3 can be found in Material Research Society Symposia Proceedings, Vol. 49, 1985, pages 423-428.

Finally, measures for reducing contamination when using a plasma CVD apparatus to deposit a-Si films are disclosed in JP-A-63 160 335.

### SUMMARY OF THE INVENTION

An object of the present invention is to provide an image sensor of amorphous silicon photodiodes having a reduced residual image.

Another object of the present invention is to provide an amorphous silicon photodiode having a ratio of the residual current to the current generated under light illumination at 50 milli-seconds (ms), after an illumination stop, of 1% or less, which level is required for a solid-state image sensor suitable for high speed reading.

The present inventor found that carbon atoms contained in an amorphous silicon contribute to the formation of capture centers, and thus have an influence on the residual current. The present invention is based on the inventor's finding.

The above-mentioned objects and other objects of the present invention are obtained by providing an amorphous silicon photodiode for an image sensor, featuring a low ratio of residual current after illumination to current under light illumination, said photodiode comprising a substrate; a lower electrode formed on the substrate; an amorphous silicon film formed on the electrode; and an upper electrode formed on the amorphous silicon film, characterized in that said amorphous silicon film is made of i-type hydrogenated amorphous silicon having a carbon content of 1 x 10¹⁸ atom/cm³ or less, to obtain said low residual current ratio by a minimization of the number of capture centers generated by the presence of carbon atoms in said amorphous silicon.

The amorphous silicon film can be formed as a double layer as stated in claim 3.

The invention also relates to a method of manufacturing the present amorphous silicon photodiode as stated in claim 5.

As the carbon content of the amorphous silicon layer is lowered, the residual current (i.e., the ratio of the residual current to the current generated under light illumination) is lowered, as explained hereinafter in detail. Preferably, the carbon content of the amorphous silicon is 1 x 10¹⁷ atom/cm³ or less, so that the ratio at 50 ms after an illumination stop is 0.5% or less.

Also, preferably the a-Si:H film has a thickness from 0.5 to 5 »m.

Preferably a doped (p-type) hydrogenated amorphous silicon carbide (p-a-SiC:H) film is formed on the a-Si:H film, since the a-SiC:H film has a superior light transmission and serves as a barrier for electrons from the upper electrode. The a-SiC:H film has a thickness thinner than the a-Si:H film, preferably from 10 to 100 nm.

To form the a-Si:H film having a carbon content of 1 x 10¹⁸ atom/cm³ or less, prior to a step of forming (depositing) the a-Si:H film on a lower electrode formed on a substrate by using a conventional plasma CVD apparatus (preferably, a parallel-plate type plasma CVD apparatus), the inside of the plasma CVD apparatus is cleaned to remove carbon compound adhering to the apparatus, and during the formation step of the a-Si:H film and the cleaning step, a vacuum condition is maintained within the plasma CVD apparatus by operating a vacuum evacuating system without a back-diffusion of oil.

Preferably the cleaning step is carried out by adopting a plasma etching process in which an etching gas of, e.g., NF₃ , is used. It is possible to use another etching gas of, e.g., CF₄ , but since this gas contains carbon, it is necessary to further carry out a first plasma etching process using a CF₄ and O₂ mixed gas and a second plasma etching process using an O₂ gas only, for a relatively long time.

Also, preferably a mechanical booster pump is used in the vacuum evacuating system. It is possible to use an oil-sealed rotary vacuum pump if a liquid nitrogen trap is furnished between the pump and the plasma CVD apparatus.

Furthermore, preferably a load-lock transfer system is used for transferring a substrate of the photodiode into or out of the plasma CVD apparatus, as thus the clean inside of the apparatus is not exposed to the air.

### BRIEF DESCRIPTION OF THE DRAWINGS

The present invention will be more apparent from the description of the preferred embodiments set forth below, with reference to the accompanying drawings, in which:
Fig. 1 is a sectional view of an amorphous silicon photodiode;
Fig 2 is an energy band diagram of the photodiode of Fig. 1;
Fig. 3 is a sectional view of an amorphous silicon photodiode having a p-a-SiC:H film formed on an i-a-Si:H film;
Fig. 4 is an energy band diagram of the photodiode of Fig. 3;
Fig. 5 is a schematic illustration of an apparatus for forming an amorphous silicon (a-Si:H) film;
Fig. 6 is a schematic illustration of an apparatus for forming an amorphous silicon (a-Si:H) film and an amorphous silicon carbide (a-SiC:H) film;
Fig. 7 is a graph showing a relationship between the carbon content in a-Si:H film and the ratio of residual current to the current generated under light illumination of amorphous silicon photodiodes with and without a-SiC:H films;
Fig. 8 is a graph showing a relationship between the carbon content in a-Si:H film formed at different substrate temperatures and the residual current ratio of amorphous silicon photodiodes;
Fig. 9 is a graph showing a relationship between the carbon content in a-Si:H film formed at different pressures in a reaction chamber and the residual current ratio; and
Fig. 10 is a graph showing a relationship between the carbon content in a-Si:H film formed at different electric power values of plasma CVD apparatus and the residual current ratio.

### DESCRIPTION OF THE PREFERRED EMBODIMENTS

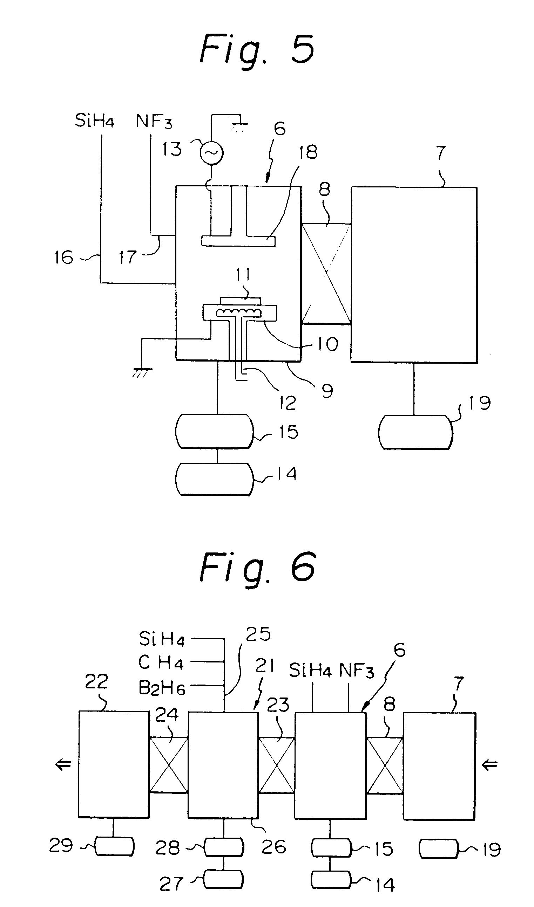

Referring to Fig. 5, an apparatus for forming (depositing) an amorphous silicon film comprises a conventional plasma CVD apparatus 6, a load-lock chamber 7 for temporarily holding a substrate, and a gate valve 8 connecting the apparatus 6 and chamber 7. The plasma CVD apparatus 6 comprises a reaction chamber 9, a bottom electrode 10, which is grounded, supports a substrate 11 thereon and heats the substrate 11 by a heater 12, a top electrode 18 connected to a high frequency power source 13, and a vacuum evacuating system including an oil-sealed type rotary pump 14 and a mechanical booster pump 15. Note, it is possible to use a turbo molecular pump instead of the mechanical booster pump 15. The reaction chamber 9 is provided with a raw material (SiH₄) gas inlet pipe 16, and an additional inlet pipe 17 for feeding an etching gas (e.g., NF₃) in accordance with the present invention. The load-lock chamber 7 is provided with a vacuum pump (e.g., an oil-sealed type rotary pump) 19 for generating a vacuum condition within the chamber 7.

An amorphous silicon photodiode shown in Fig. 1 is produced in the following manner using the amorphous silicon formation apparatus shown in Fig. 5, while reducing a carbon content of the amorphous silicon to less than 1 x 10¹⁸ atom/cm³

An insulating substrate (e.g., glass substrate) 1 is prepared and is coated with a metal film 2 of, e.g., chromium, the substrate 1 is set within the load-lock chamber 7 and the chamber 7 is evacuated with the vacuum pump 19, and the reaction chamber 9 of the plasma CVD apparatus 6 is evacuated first by the rotary pump 14 and second by the mechanical pump 15, to generate a high vacuum condition. The etching gas (e.g., NF₃) is fed into the reaction chamber 9 through the inlet pipe 17, and simultaneously, a high frequency (e.g., 13.56 MHz) voltage is applied to the top electrode 18 to create a glow discharge, so that the inside surface of the chamber 9 and the surfaces of both electrodes 10 and 18 are cleaned by a plasma etching process. After the plasma etching process, the gate valve 8 is opened and the substrate 11 is set on the bottom electrode 10 from outside the chamber 7 by a suitable transfer device (not shown). The substrate 11 is then heated by the heater at a temperature of from 200 to 280°C, the raw material gas (SiH₄) is fed into the reaction chamber 9 through the inlet pipe 16, and the inside pressure (vacuum pressure) of the reaction chamber 9 is maintained of 0.5 to 2.0 Torr. It is possible to add a diluent gas such as H₂ , Ar and He to the raw material gas, if required. The high frequency (5 to 30 MHz, preferably 13.56 Hz) voltage is applied to the top electrode 18 at a power density of 10 to 100 mW/cm² to create a glow discharge between the two electrodes 11 and 18, and as a result, an i-a-Si:H is deposited on the metal electrode 2 to form the amorphous silicon film 3 (Fig. 1) containing carbon atoms at 1 x 10¹⁸/cm³ or less.

After the formation of the amorphous silicon film 3, the substrate 11 is transferred into the load-lock chamber 7 through the gate valve 8, the inside pressure of the chamber 7 is restored to the atmospheric (air) pressure, and the substrate is removed. Then a transparent conductive film (e.g., ITO film) 4 is formed on the amorphous silicon layer 3, as shown in Fig. 1, to produce the amorphous silicon photodiode having a ratio of the residual current to the current generated under light illumination of 1% or less.

Another amorphous silicon photodiode shown in Fig. 3 is produced by using an amorphous silicon film formation apparatus, as shown in Fig. 6, which comprises the plasma CVD apparatus 6, the load-lock chamber 7 and the gate valve 8, which are the same as those of Fig. 5, another plasma CVD apparatus 21, another load-lock chamber 22, and two gate valves 23 and 24. The plasma CVD apparatus 21 is used for forming a p-a-SiC:H film 32 and has the same structure as that of the apparatus 6, except that a gas inlet pipe 25 is connected to three gas sources of SiH₄ , CH₄ and B₂H₆. The load-lock chamber 22 has the same structure as that of the chamber 7, the gate valve 23 connects the apparatuses 6 and 21, and the gate valve 24 connects the apparatus 21 and the chamber 22.

An amorphous silicon (i-a-Si:H) film 31 (Fig. 3) is formed by using the plasma CVD apparatus 6 in the same manner as for formation of the i-a-Si:H film 3 (Fig. 1). Next, the substrate with the film 31 is transferred into the plasma CVD apparatus 21 through the gate valve 23, a reaction chamber 26 of the apparatus 21 is evacuated with an oil-sealed type rotary pump 27 and a mechanical booster pump 28, the SiH₄ , CH₄ and B₂H₆ mixed gas is fed into the reaction chamber 26 through the pipe 25, and a high frequency (e.g., 13.56 MHz) voltage is applied to a top electrode of two parallel plates, a bottom electrode of which is grounded and supports and heats the substrate to create a glow discharge under conventional conditions. As a result, p-a-SiC:H is deposited on the i-a-Si:H film 31 to form the a-SiC:H film 32 (Fig. 2) having a thickness of from 10 to 100 nm. Then the substrate with the films 31 and 32 is transferred into the load-lock chamber 22 evacuated with an oil-sealed rotary pump 29, through the gate valve 24. After the vacuum condition in the chamber 22 is eliminated, the substrate is removed from the chamber 22, and the transparent conductive film (ITO film) 4 is formed on the p-a-SiC:H film 32, as shown in Fig. 3, to produce another photodiode having properties superior to those of the photodiode of Fig. 1.

### Example 1

Many samples of amorphous silicon photodiodes shown in Figs. 1 and 3 were produced as follows:

A glass substrate of each of the samples was coated with a Cr film (lower electrode), and an i-a-Si:H film having a thickness of 1 »m was deposited on the Cr film by a parallel-plate type plasma CVD apparatus shown in Fig. 5, under the following conditions:
Raw material gas: SiH₄
Pressure in reaction chamber: 1.0 Torr
Substrate temperature: 250°C
Frequency of electric power: 13.56 MHz
Power density: 30 mW/cm²

To vary a carbon content of the Si:H film of the samples, the following parameters were adopted, as appropriate.

Use or non-use of a load-lock chamber (Fig. 5);
Enforcement or non-enforcement of a cleaning step with plasma etching (NF₃ etching gas);
Time of cleaning step;
Time of exposure of the reaction chamber;
Use or non-use of mechanical booster pump.

On half of the samples a p-a-SiC:H film having a thickness of 20 nm was deposited on the i-a-Si:H film by another parallel-plate type plasma CVD apparatus shown in Fig. 6, using a SiH₄ , CH₄ and B₂H₆ mixed gas.

All of the samples were coated with an ITO film to complete the photodiodes.

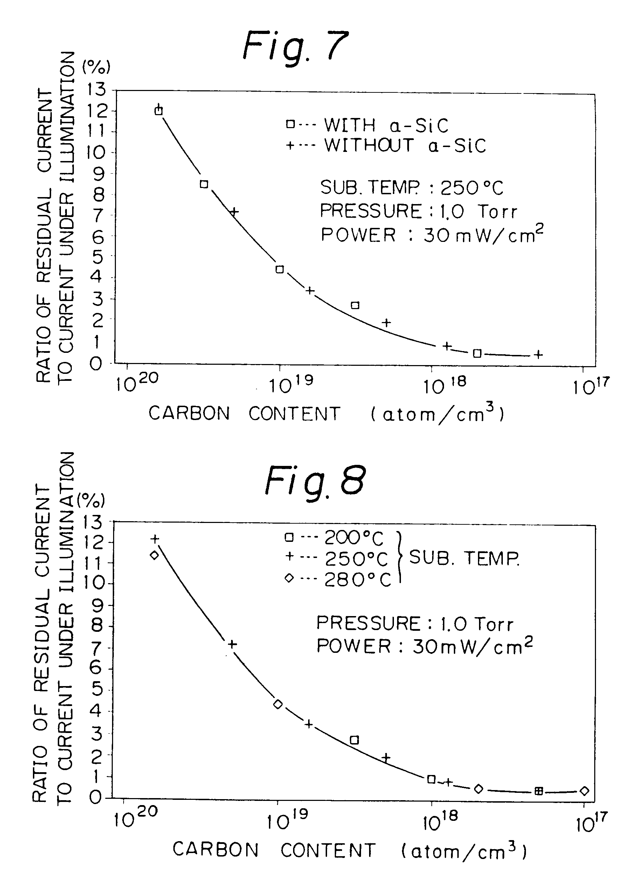

The obtained photodiodes were tested to measure the ratio of the residual current to the current generated under light illumination (by an LED having a wavelength of 550 nm), 50 ms after the illumination was stopped, while the ITO film was biased by -5 V. A carbon content of the i-a-Si:H films of the photodiodes was measured with SIMS, and the data obtained is shown in Fig. 7.

As can be seen from Fig. 7, as the carbon content was lowered, the ratio of residual current to the current under illumination was lowered. A carbon content of no more than 1 x 10¹⁸ atom/cm³ obtained a ratio of 1% or less. Also, regardless of the formation or nonformation of the p-a-SiC:H film, the photodiodes without the a-SiC:H films provided substantially the same data as that of the photodiodes with the a-SiC:H films.

### Example 2

Many samples of amorphous silicon photodiodes shown in Fig. 3 were produced as follows:

A glass substrate of each of the samples was coated with a Cr film, and an i-a-Si:H film having a thickness of 1 »m was deposited on the Cr film by the plasma CVD apparatus under the same conditions as for Example 1, except that the substrate temperature was varied at 200°C, 250°C, and 280°C.

Without breaking the vacuum condition, a p-a-SiC:H film having a thickness of 20 nm was deposited on the i-a-Si:H film by another plasma CVD apparatus, using the SiH₄ , CH₄ and B₂H₆ mixed gas, and then an ITO film was deposited on the a-SiC:H film to complete the photodiodes.

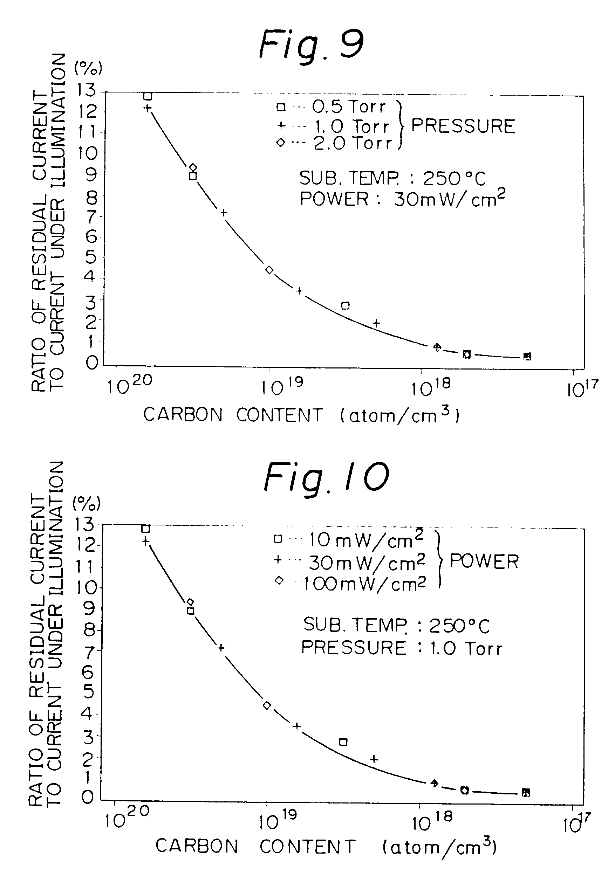

The obtained photodiodes were tested to measure the ratio of residual current to the current under illumination in the same manner as in Example 1. The carbon content of the i-a-Si:H films was measured, and data obtained is shown in Fig. 8.

### Example 3

Many samples of amorphous silicon photodiodes shown in Fig. 3 were produced as follows:

A glass substrate of each of the samples was coated with a Cr film, and an i-a-Si:H film having a thickness of 1 »m was deposited on the Cr film by the plasma CVD apparatus under the same conditions as in Example 1, except that the pressure in the reaction chamber was varied at 0.5 Torr, 1.0 Torr, and 2.0 Torr.

Without breaking the vacuum condition, a p-a-SiC:H film having a thickness of 20 nm was deposited on the i-a-Si:H film by another plasma CVD apparatus, using the SiH₄ , CH₄ and B₂H₆ mixed gas, and then an ITO film was deposited on the a-SiC:H film to complete the photodiodes.

The obtained photodiodes were tested to measure the ratio of residual current to the current under illumination, in the same manner as in Example 1. The carbon content of the i-a-Si:H films was measured and the data obtained is shown in Fig. 9.

### Example 4

Many samples of amorphous silicon photodiodes shown in Fig. 3 were produced as follows:

A glass substrate of each of the samples was coated with a Cr film, and an i-a-Si:H film having a thickness of 1 »m was deposited on the Cr film by the plasma CVD apparatus under the same conditions as in Example 1, except that the power density of the electric power source was varied at 10, 30, and 100 mW/cm².

Without breaking the vacuum condition, a p-a-SiC:H film having a thickness of 20 nm was deposited on the i-a-Si:H film by another plasma CVD apparatus, using the SiH₄ , CH₄ and B₂H₆ mixed gas, and then an ITO film was deposited on the a-SiC:H film to complete the photodiodes.

The obtained photodiodes were tested to measure the ratio of residual current to the current under illumination, in the same manner as in Example 1. The carbon content of the i-a-Si:H films was measured and the data obtained is shown in Fig. 10.

As can be seen from Figs. 8, 9 and 10 as the carbon content is reduced, the ratio of residual current to the current under illumination is lowered. A carbon content of no more than 1 x 10¹⁸ atom/cm³ obtained a ratio of 1% or less. Regardless of variations of the parameters (substrate temperature, pressure and power), the photodiodes have almost the same residual ratio at a certain carbon content, and therefore, it is obvious that the carbon atoms generate the capture centers in the energy band diagram of the a-Si:H film, which cause the residual current. Where a solid state image sensor is made of a large number of photodiodes using amorphous silicon containing a lower number of carbon atoms, the residual image of the sensor is remarkably reduced.

Although the above examples use a-SiC:H, the invention can also be implemented using a-SiC:H:F instead.

## Claims

1. An amorphous silicon photodiode for an image sensor, featuring a low ratio of residual current after illumination to current under light illumination, said photodiode comprising a substrate (1); a lower electrode (2) formed on the substrate; an amorphous silicon film (3) formed on the electrode; and an upper electrode (4) formed on the amorphous silicon film, characterized in that said amorphous silicon film is made of i-type hydrogenated amorphous silicon having a carbon content of 1 x 10¹⁸ atom/cm³ or less, to obtain said low residual current ratio by a minimization of the number of capture centers generated by the presence of carbon atoms in said amorphous silicon.

2. An amorphous silicon photodiode according to claim 1, wherein said upper electrode (4) is a transparent conductive film.

3. An amorphous silicon photodiode for an image sensor, featuring a low ratio of residual current after illumination to current under light illumination, said photodiode comprising a substrate (1); a lower electrode (2) formed on the substrate; an amorphous silicon film (31, 32) formed on the electrode and an upper electrode (4) formed on the amorphous silicon film, said amorphous silicon film having a double layer structure comprised of a lower film (31) of i-type hydrogenated amorphous silicon and an upper film (32) of p-type hydrogenated amorphous silicon carbide, characterized in that said i-type hydrogenated amorphous silicon film (31) has a carbon content of 1 x 10¹⁸ atom/cm³ or less, to obtain said low residual current ratio by a minimization of the number of capture centers generated by the presence of carbon atoms in said amorphous silicon.

4. An amorphous silicon photodiode according to claim 3, wherein said upper electrode (4) is a transparent conductive layer.

5. A method of producing an amorphous silicon photodiode according to claim 1 or 3 comprising the steps of: forming a lower electrode (2) on a substrate (1); forming an amorphous silicon film (3; 31, 32) on the lower electrode by using a plasma CVD apparatus (6); and forming an upper electrode (4) on the amorphous silicon film; characterized in that it further comprises the steps of cleaning the inside of said plasma CVD apparatus (6) prior to the step of formation of said amorphous silicon film to remove residual carbon compound, and during the formation step of said amorphous silicon film and the cleaning step, maintaining a vacuum condition by using a vacuum evacuating system (24, 29) without a back-diffusion of oil.

6. A method according to claim 5, wherein the amorphous silicon photodiode to be produced is transferred into or out of said plasma CVD apparatus (6) by a load-lock transfer system (7).

7. A method according to claim 5, wherein said cleaning step is carried out by a plasma etching process.

8. A method according to claim 7, wherein said cleaning step is carried out by a plasma etching process using NF₃ gas.

9. A method according to claim 5, wherein said vacuum evacuating system uses a mechanical booster pump (29).

## Patentansprüche

1. Photodiode aus amorphem Silizium für einen Bildsensor, bei der ein Merkmal in einem niedrigen Verhältnis von Reststrom nach der Beleuchtung zu dem Strom unter Beleuchtung mit Licht besteht, wobei die Photodiode folgendes aufweist: ein Substrat (1); eine auf dem Substrat ausgebildete untere Elektrode (2); eine auf der Elektrode ausgebildete Schicht (3) aus amorphem Silizium; und eine auf der Schicht aus amorphem Silizium ausgebildete obere Elektrode (4),
dadurch gekennzeichnet, daß die Schicht aus amorphem Silizium aus i-leitendem hydrierten amorphen Silizium besteht, das einen Kohlenstoffgehalt von 1 x 10¹⁸ Atomen/cm³ oder weniger besitzt, um das niedrige Reststromverhältnis durch eine Minimierung der Anzahl der durch das Vorhandensein von Kohlenstoffatomen in dem amorphen Silizium erzeugten Einfangzentren zu erzielen.

2. Photodiode aus amorphem Silizium nach Anspruch 1, wobei es sich bei der oberen Elektrode (4) um eine transparente leitfähige Schicht handelt.

3. Photodiode aus amorphem Silizium für einen Bildsensor, bei der ein Merkmal in einem niedrigen Verhältnis von Reststrom nach der Beleuchtung zu dem Strom unter Beleuchtung mit Licht besteht, wobei die Photodiode folgendes aufweist: ein Substrat (1); eine auf dem Substrat ausgebildete untere Elektrode (2); eine auf der Elektrode ausgebildete Schicht (31, 32) aus amorphem Silizium;
und eine auf der Schicht aus amorphem Silizium ausgebildete obere Elektrode (4), wobei die Schicht aus amorphem Silizium eine doppellagige Konstruktion aus einer unteren Schicht (31) aus i-leitendem hydrierten amorphen Silizium und einer oberen Schicht (32) aus p-leitendem hydrierten amorphen Siliziumkarbid aufweist,
dadurch gekennzeichnet, daß die i-leitende Schicht (31) aus hydriertem amorphen Silizium einen Kohlenstoffgehalt von 1 x 10¹⁸ Atomen/cm³ oder weniger besitzt, um das niedrige Reststromverhältnis durch eine Minimierung der Anzahl der durch das Vorhandensein von Kohlenstoffatomen in dem amorphen Silizium erzeugten Einfangzentren zu erzielen.

4. Photodiode aus amorphem Silizium nach Anspruch 3, wobei es sich bei der oberen Elektrode (4) um eine transparente leitfähige Schicht handelt.

5. Verfahren zum Herstellen einer Photodiode aus amorphem Silizium nach Anspruch 1 oder 3, das folgende Schritte aufweist: Bilden einer unteren Elektrode (2) auf einem Substrat (1); Bilden einer Schicht (3; 31, 32) aus amorphem Silizium auf der unteren Elektrode unter Verwendung einer Plasma-CVD-Vorrichtung (6); und Bilden einer oberen Elektrode (4) auf der Schicht aus amorphem Silizium; dadurch gekennzeichnet, daß es folgende weitere Schritte umfaßt:
Reinigen des Inneren der Plasma-CVD-Vorrichtung (6) vor dem Schritt der Bildung der Schicht aus amorphem Silizium zum Entfernen restlicher Kohlenstoffverbindungen,
und während des Schrittes der Bildung der Schicht aus amorphem Silizium sowie des Reinigungsschrittes erfolgende Aufrechterhaltung eines Vakuumzustands durch Verwendung eines Vakuum-Evakuierungssystems (24, 29) ohne Rückdiffusion von Öl.

6. Verfahren nach Anspruch 5,
wobei die zu erzeugende Photodiode aus amorphem Silizium durch ein Schleusen-Transfersystem (7) in die Plasma-CVD-Vorrichtung (6) hinein und aus dieser heraus befördert wird.

7. Verfahren nach Anspruch 5,
wobei der Reinigungsschritt durch einen Plasmaätzvorgang ausgeführt wird.

8. Verfahren nach Anspruch 7,
wobei der Reinigungsschritt durch einen Plasmaätzvorgang unter Verwendung von NF₃-Gas ausgeführt wird.

9. Verfahren nach Anspruch 5,
wobei das Vakuum-Evakuierungssystem eine mechanische Verstärkungspumpe (29) verwendet.

## Revendications

1. Photodiode en silicium amorphe pour capteur d'image, qui présente un faible rapport du courant résiduel après éclairement au courant pendant l'éclairement, ladite photodiode comprenant : un substrat (1) ; une électrode inférieure (2) formée sur le substrat ; une pellicule de silicium amorphe (3) formée sur l'électrode ; et une électrode supérieure (4) formée sur la pellicule de silicium amorphe, caractérisée en ce que ladite pellicule de silicium amorphe est faite de silicium amorphe hydrogéné de type i ayant une teneur en carbone de 1 x 10¹⁸ atomes/cm³ ou moins, de sorte qu'on obtient ledit rapport faible de courant résiduel en minimisant le nombre de centres de capture créés par la présence d'atomes de carbone dans ledit silicium amorphe.

2. Photodiode en silicium amorphe selon la revendication 1, où ladite électrode supérieure (4) est une pellicule conductrice transparente.

3. Photodiode en silicium amorphe pour capteur d'image, qui présente un faible rapport du courant résiduel après éclairement au courant pendant l'éclairement, ladite photodiode comprenant : un substrat (1); une électrode inférieure (2) formée sur le substrat ;une pellicule de silicium amorphe (31, 32) formée sur l'électrode ; et une électrode supérieure (4) formée sur la pellicule de silicium amorphe, ladite pellicule de silicium amorphe ayant une structure en couche double constituée d'une pellicule inférieure (31) de silicium amorphe hydrogéné de type i et d'une pellicule supérieure (32) de carbure de silicium amorphe hydrogéné de type p, caractérisée en ce que ladite pellicule de silicium amorphe hydrogéné de type i (31) possède une teneur en carbone de 1 x 10¹⁸ atomes/cm³ ou moins, de sorte qu'on obtient ledit rapport faible de courant résiduel en minimisant le nombre de centres de capture créés par la présence d'atomes de carbone dans ledit silicium amorphe.

4. Photodiode en silicium amorphe selon la revendication 3, où ladite électrode supérieure (4) est une couche conductrice transparente.

5. Procédé de production d'une photodiode en silicium amorphe selon la revendication 1 ou 3, qui comprend les opérations suivantes : former une électrode inférieure (2) sur un substrat (1) ; former une pellicule de silicium amorphe (3; 31, 32) sur l'électrode inférieure à l'aide d'un appareil CVD à plasma (6) ; et former une électrode supérieure (4) sur la pellicule de silicium amorphe, caractérisé en ce qu'il comprend en outre les opérations consistant à nettoyer l'intérieur dudit appareil CVD à plasma (6) avant l'opération de formation de ladite pellicule de silicium amorphe afin d'éliminer les composés carbonés résiduels, et, pendant l'opération de formation de ladite pellicule de silicium amorphe et l'opération de nettoyage, maintenir un état de vide à l'aide d'un système d'aspiration (24, 29) n'ayant pas de diffusion d'huile en retour.

6. Procédé selon la revendication 5, où on transfère la photodiode de silicium amorphe, à produire, dans ledit appareil CVD à plasma (6) ou hors de cet appareil à l'aide d'un système de transfert à sas de chargement (7).

7. Procédé selon la revendication 5, où on effectue ladite opération de nettoyage à l'aide d'un processus de gravure par plasma.

8. Procédé selon la revendication 7, où on effectue ladite opération de nettoyage à l'aide d'un processus de gravure par plasma utilisant le gaz NF₃.

9. Procédé selon la revendication 5, où ledit système d'aspiration utilise une pompe relais mécanique (29).
